# FASCICULE DE BREVET EUROPEEN

(11) **EP 2 694 588 B1**
(45) Date de publication et mention de la délivrance du brevet: **22.04.2015**
(21) Numéro de dépôt: 12711189.6
(22) Date de dépôt: 30.03.2012
(51) Int. Cl.: C08L 77/00, C08K 3/22, C08K 3/04, C08K 5/3492, C08K 5/00

(54) **COMPOSITION POLYAMIDE DE FORTE CONDUCTIVITE THERMIQUE**
POLYAMIDZUSAMMENSETZUNG MIT HOHER WÄRMELEITFÄHIGKEIT
POLYAMIDE COMPOSITION HAVING HIGH THERMAL CONDUCTIVITY

(30) Priorité: 04.04.2011 FR 1152863
(43) Date de publication de la demande: 12.02.2014
(73) Titulaire: Rhodia Operations, 93306 Aubervilliers (FR)
(72) Inventeur: KIM, Tae-Kyun, Gyeonggi-do (KR); YU, Yeong Chool, Seoul 157-836 (KR)
(74) Mandataire: Valentino, Cédric
(86) Numéro de dépôt international: PCT/EP2012/055821
(87) Numéro de publication internationale: WO 2012/136590

(56) Documents cités:
- WO-A1-2006/135841
- WO-A1-2009/019186
- DE-A1-102008 038 411

## Description

La présente invention concerne une composition à base de matrice polyamide présentant une forte conductivité thermique et comprenant des proportions spécifiques d'alumine et de graphite ainsi qu'un système ignifugeant. Cette composition peut notamment servir à la réalisation de composants pour des appareils d'éclairage comprenant des diode luminescentes.

### ART ANTERIEUR

Le polyamide est un polymère synthétique largement utilisé pour la fabrication de divers articles, tels que des pièces moulées et/ou injectées. Les polyamides techniques sont utilisés pour la réalisation de nombreux articles dans différents domaines, comme le domaine de l'automobile, de l'électrique ou de l'électronique où des propriétés spécifiques de rigidité, de résistance aux chocs, de stabilité dimensionnelle, en particulier à températures relativement élevées, d'aspect de surface, de densité et de poids sont particulièrement recherchées. Le choix d'un matériau pour une application donnée est généralement guidé par le niveau de performances exigées vis-à-vis de certaines propriétés et par son coût. On cherche en effet toujours de nouveaux matériaux susceptibles de répondre à un cahier des charges en terme de performance et/ou de coûts.

Il est connu de l'art antérieur d'utiliser des polyamides techniques présentant une bonne conductivité thermique pour diverses applications, notamment dans le domaine de l'électrique et de l'électronique, lorsqu'ils sont utilisés avec des semi-conducteurs, des moteurs ou des qui composants émettent ou interagissent avec la lumière. A ce titre les diodes électroluminescentes (DEL), ou LED en anglais, sont des composants électroniques capables d'émettre de la lumière lorsqu'ils sont parcourus par un courant électrique ; ce courant électrique générant une forte chaleur qu'il convient alors de dissiper pour éviter des surchauffes et des dommages consécutifs.

Il est connu d'employer des composants en polyamide pour la réalisation de tels articles comprenant des DEL en utilisant des additifs capables d'augmenter la conductivité thermique du polyamide tels que le graphite ou le nitrure de bore, par exemple. Toutefois, l'utilisation du graphite dans le polyamide conduit à une forte augmentation également de la conductivité électrique, comme notamment mentionné dans le document FR2596567.

Il existe ainsi un besoin de concevoir des compositions à base de polyamide présentant une forte conductivité thermique et également une faible conductivité électrique, c'est-à-dire une bonne isolation électrique, tout en présentant un bon compromis de propriétés mécaniques et de résistance à l'ignifugation pour diverses applications.

Il était par ailleurs connu que l'alumine lorsqu'il est utilisé dans de très fortes proportions dans le polyamide permettait de conférer une certaine conductivité thermique. Toutefois, une telle proportion d'alumine dans la matrice détériore drastiquement les propriétés mécaniques et rhéologiques de la composition polyamide.

### INVENTION

La demanderesse vient de mettre en évidence que la combinaison de graphite et d'alumine dans des proportions spécifiques permettait de résoudre les problèmes mentionnés précédemment et d'obtenir des compositions polyamides présentant une forte conductivité thermique et également une conductivité électrique adéquate, tout en présentant un bon compromis de propriétés mécaniques et de résistance à l'ignifugation.

Ceci est surprenant dans la mesure où il était connu que le graphite permettait d'augmenter les conductivités thermiques et électriques dans le polyamide comme explicité précédemment et que l'alumine lorsqu'il est utilisé dans de très fortes proportions permettrait d'augmenter la conductivité thermique sans affecter la conductivité électrique.

La présente invention a ainsi pour premier objet une composition comprenant au moins :
a) une matrice polyamide;
b) de 2 à 30 % en poids d'alumine ;
c) de 15 à 50 % en poids de graphite ; et
d) de 5 à 40 % en poids d'un système ignifugeant
les pourcentages en poids sont exprimés par rapport au poids total de la composition.

La matrice polyamide comprend préférentiellement un polyamide thermoplastique et plus préférentiellement un polyamide thermoplastique semi-cristallin. On préfère notamment les polyamides semi-cristallins aliphatiques ou semi-aromatiques.

Le polyamide à utiliser selon l'invention est notamment choisi dans le groupe comprenant les polyamides obtenus par polycondensation d'au moins un diacide carboxylique aliphatique avec une diamine aliphatique ou cyclique ou cycloaliphatique ou arylaliphatique comme le PA 6.6, PA6.10, PA6.12, PA 10.10, PA 10.6, PA 12.12, PA 4.6, MXD 6, PA 92 ou entre au moins un diacide carboxylique aromatique et une diamine aliphatique ou aromatique comme les polytéréphtalamides, polyisophtalamides, polyaramides, ou leur mélange et (co)polyamides. Le polyamide à utiliser selon l'invention peut aussi être choisi dans les polyamides obtenus par polycondensation d'au moins un aminoacide ou lactame sur lui-même, l'aminoacide pouvant être généré par l'ouverture hydrolytique d'un cycle lactame tels que, par exemple PA 6, PA 7, PA 11, PA 12, PA 13 ou leur mélange et (co)polyamides. Comme type de copolyamide on peut notamment citer le polyamide 6/66.

On préfère particulièrement les polyamides de type 6 et les polyamide de type 66. On entend notamment par polyamide de type 6 un polyamide comprenant au moins 90 % en poids de résidus de monomères caprolactame ou aminocaproïque. On entend notamment par polyamide de type 66 un polyamide comprenant au moins 90 % en poids de résidus de monomères acide adipique et hexaméthylènediamine.

Les polyamides peuvent présenter une viscosité apparente en phase fondue comprise entre 10 et 1200 Pa.s, mesuré selon la norme ISO 11443 à un taux de cisaillement de 1000 s⁻¹ et une température de 250°C, notamment pour les polyamide de type 6 ; ou une viscosité apparente en phase fondue comprise entre 10 et 700 Pa.s, mesuré selon la norme ISO 11443 à un taux de cisaillement de 1000 s⁻¹ et une température de 280°C, notamment pour les polyamide de type 66.

On peut notamment utiliser des polyamides de poids moléculaires variables par addition avant ou pendant la polymérisation des monomères de polyamide, ou encore en voie fondue à l'extrusion, de monomères modifiant la longueur des chaînes, tel que notamment des composés difonctionnels et/ou monofonctionnels présentent des fonctions amines ou acides carboxyliques capables de réagir avec les monomères du polyamide ou le polyamide.

Par acide carboxylique, on entend les acides carboxyliques et leurs dérivés, tels que les anhydrides d'acide, les chlorures d'acide et les esters, par exemple. Par amine, on entend les amines et leurs dérivés capables de former une liaison amide.

On peut utiliser au début, en cours ou en fin de polymérisation tout type d'acides mono- ou di-carboxylique, aliphatiques ou aromatiques ou tout types d'amines mono- ou di-amines, aliphatiques ou aromatiques.

On peut utiliser tout particulièrement un polyamide obtenu au moins à partir d'acide adipique et d'hexaméthylène diamine ou de leurs sels tels que l'adipate d'hexaméthylènediamine, pouvant éventuellement comprendre diverses proportions d'autres monomères de polyamide. On peut citer à cet effet le polyamide 66/6T.

Des polyamides selon l'invention peuvent aussi être obtenus par mélange, notamment en fondu. On peut par exemple mélanger un polyamide avec un autre polyamide, ou un polyamide avec un oligomère de polyamide, ou encore un polyamide avec des monomères modifiant la longueur des chaînes, tel que notamment des diamines, diacides carboxyliques, monoamines et/ou monoacides carboxyliques. On peut notamment ajouter au polyamide de l'acide isophtalique, de l'acide téréphtalique ou de l'acide benzoïque, par exemple à des teneurs d'environ 0,2 à 2 % en poids.

La composition de l'invention peut également comprendre les copolyamides dérivés notamment des polyamides ci-dessus, ou les mélanges de ces polyamides ou (co)polyamides.

On peut également utiliser des polyamides branchés de haute fluidité notamment obtenus par mélange en polymérisation, en présence des monomères de polyamide, d'au moins un composé multifonctionnel comprenant au moins 3 fonctions réactives identiques de type fonction amine ou fonction acide carboxylique.

On peut également utiliser comme polyamide de haute fluidité un polyamide étoile comprenant des chaînes macromoléculaires étoiles et le cas échéant des chaînes macromoléculaires linéaires. Les polymères comprenant de telles chaînes macromoléculaires étoiles sont par exemple décrits dans les documents WO97/24388 et WO99/64496.

Ces polyamides étoiles sont notamment obtenus par mélange en polymérisation, en présence des monomères de polyamide, un aminoacide ou lactame tel que le caprolactame, d'au moins un composé multifonctionnel comprenant au moins 3 fonctions réactives identiques de type fonction amine ou fonction acide carboxylique. Par acide carboxylique, on entend les acides carboxyliques et leurs dérivés, tels que les anhydrides d'acide, les chlorures d'acide et les esters, par exemple. Par amine, on entend les amines et leurs dérivés capables de former une liaison amide.

La composition peut comprendre, outre le polyamide modifié de l'invention, un ou plusieurs autres polymères, de préférence polyamides ou copolyamides. La composition peut également comprendre, selon la propriété finale souhaitée, un mélange de polyamide modifié selon l'invention et un ou plusieurs autres polymères, tel que par exemple du polyamide, du polyester, des polyoléfines, du polystyrène, de la résine ABS, du polycarbonate, du sulfure de polyphénylène, de l'oxyde de polyphénylène, du polyacétal, du polysulfone, de la polyéthersulfone, du polyétherimide, de la polyéthercétone, une résine d'acide polylactique, une résine de polysulfone, une résine élastomère ou des mélanges de ceux-ci.

La composition selon l'invention peut comprendre entre 20 et 80 % en poids, préférentiellement entre 20 et 60 % en poids, et plus préférentiellement entre 25 et 55% en poids de polyamide, par rapport au poids total de la composition.

L'alumine ou oxyde d'aluminium est un composé de formule chimique Al₂O₃ pouvant se présenter sous forme de particules ayant un notamment une taille moyenne comprise entre 0,1 et 100 µm. L'alumine peut notamment présenter une taille moyenne inférieure à 50 µm.

La composition selon la présente invention comprend préférentiellement de 2 à 20 % en poids d'alumine, plus préférentiellement de 2 à 15 % en poids d'alumine.

Le graphite peut être d'origine naturelle ou artificielle et il peut être sous forme d'écailles, de poudre, de grumeaux, de grains ou d'agglomérats. La taille des particules de graphite peut être comprise entre 0,1 et 100 µm. On peut notamment citer le graphite tel que décrit dans le document Plastics Additives, Hanser Publishers, 4th Edition, 1996.

Le graphite peut être utilisé en tant que tel ou sous forme de mélange maitre dans une résine par exemple à base de polyoléfine, d'élastomère ou phénolique.

La composition selon la présente invention comprend préférentiellement de 20 à 40 % en poids de graphite, plus préférentiellement de 20 à 35 % en poids de graphite.

Le système d'ignifugation selon la présente invention peut comprendre tout type d'agents ignifugeants, c'est à dire des composés permettant de diminuer la propagation de la flamme et/ou ayant des propriétés d'ignifugation, bien connus de l'homme du métier. Ces agents ignifugeants sont habituellement utilisés dans des compositions ignifugées et sont notamment décrits, par exemple, dans les brevets US6344158, US6365071, US6211402 et US6255371, cités ici à titre de référence.

Avantageusement, le système d'ignifugation comprend au moins un agent ignifugeant choisi parmi le groupe comprenant :
* les agents ignifugeants contenant du phosphore, tels que :
   - les oxydes de phosphines comme par exemple l'oxyde de triphénylphosphine, l'oxyde de tri-(3-hydroxypropyl) phosphine et l'oxyde de tri-(3-hydroxy-2-méthylpropyl) phosphine.
   - les acides phosphoniques ou leurs sels ou les acides phosphiniques ou leurs sels, tels que par exemple les sels d'acides phosphiniques de zinc, de magnésium, de calcium, d'aluminium, ou de manganèse, notamment le sel d'aluminium de l'acide diéthylphosphinique ou le sel de zinc de l'acide diméthylphosphinique.
   - les phosphonates cycliques, tels que les esters de diphosphate cyclique tel que par exemple l'Antiblaze 1045.
   - les phosphates organiques, tels que le triphénylphosphate.
   - les phosphates inorganiques, tels que les polyphosphates d'ammonium et les polyphosphates de sodium.
   - le phosphore rouge, qu'il soit par exemple sous forme stabilisé ou revêtu, en poudre ou sous forme de masterbatches.
* les agents ignifugeants de type composés organiques azotés tels que par exemple les triazines, l'acide cyanurique et/ou isocyanurique, la mélamine ou ses dérivés comme le cyanurate de mélamine, l'oxalate, le phtalate, le borate, le sulfate, le phosphate, polyphosphate et/ou pyrophosphate de mélamine, les produits condensés de la mélamine, tel que le mélem, le mélam et le mélon, le tris(hydroxyéthyl) isocyanurate, la benzoguanamine, la guanidine, l'allantoïne, et le glycoluril.
* les agents ignifugeants contenant des dérivés halogénés, tels que :
   - les dérivés du brome tels que par exemple les PBDPO (polybromodiphényloxydes), le BrPS (polystyrène bromé et polybromostyrène), le poly(pentabromobenzylacrylate), l'indane bromé, le tétradécabromodiphénoxybenzène (Saytex 120), l'éthane-1,2-bis(pentabromophényl) ou Saytex 8010 d'Albemarle, le tétrabromobisphénol A et les oligomères époxy bromés. Notamment parmi les dérivés bromés, nous pouvons citer le polydibromostyrène tel que le PDBS-80 de Chemtura, les polystyrènes bromés tels que le Saytex HP 3010 d'Albemarle ou le FR-803P de Dea Sea Bromine Group, le décabromodiphényléther (DBPE) ou FR-1210 de Dea Sea Bromine Group, l'octabromodiphényléther (OBPE), le 2,4,6-Tris(2,4,6-tribromophénoxy)-1,3,5 triazine ou FR-245 de Dead Sea Bromine Group, le Poly(pentabromobenzylacrylate) ou FR-1025 de Dead Sea Bromine Group et les oligomères ou polymères à terminaisons époxy du tétrabromobisphénol-A comme tels que les F-2300 et F2400 de Dead Sea Bromine Group.
   - les composés chlorés, tel que par exemple un composé cycloaliphatique chloré comme le Dechlorane plus® (vendu par OxyChem, voir CAS 13560-89-9).

Le système d'ignifugeant comprend préférentiellement au moins un acide phosphonique ou son sel ou un acides phosphinique ou son sel.

Ces composés peuvent être utilisés seuls ou en combinaison, parfois synergique. On préfère notamment une association synergique de composés contenant du phosphore comme les oxydes de phosphines, les acides phosphoniques ou leurs sels ou les acides phosphiniques ou leurs sels, et les phosphonates cycliques ; avec des dérivés azotés tels que le mélam, le mélem, le phosphate de mélamine, les polyphosphates de mélamine, les pyrophosphates de mélamine ou les polyphosphates d'ammonium.

La composition peut comprendre de 5 à 20 % en poids d'agents ignifugeants, par rapport au poids total de la composition, notamment dans le cadre de l'utilisation des agents ignifugeants contenant du phosphore, tels que les acides phosphiniques ou leurs sels.

La composition peut comprendre des charges de renfort ou de remplissages, tels que par exemple des charges fibreuses et/ou des charges non fibreuses. Comme charges fibreuses on peut citer les fibres de verre, les fibres de carbone, les fibres naturelles, les fibres d'aramides, et les nanotubes, notamment de carbone. On peut citer comme fibres naturelles le chanvre et le lin. Parmi les charges non fibreuses on peut notamment citer toutes les charges particulaires, lamellaires et/ou les nanocharges exfoliables ou non exfoliables, le noir de carbone, les argiles alumino-silicates, les montmorillonites, le phosphate de zirconium, le kaolin, le carbonate de calcium, les diatomées, le graphite, le mica, la silice, le dioxyde de titane, les zéolites, le talc, la wollastonite, les charges polymériques telles que, par exemple, des particules de diméthacrylates, les billes de verre ou de la poudre de verre. La concentration pondérale des charges de renfort peut être comprise avantageusement entre 1 % et 50 % en poids par rapport au poids total de la composition, de préférence entre 15 et 50 %.

Les compositions de l'invention peuvent également comprendre tous les additifs habituellement utilisés dans les compositions à base de polyamide utilisées pour la fabrication d'articles moulés ou extrudés. Ainsi, on peut citer à titre d'exemple d'additifs les stabilisants thermiques, stabilisants U.V., antioxydants, lubrifiants, pigments, colorants, plastifiants ou des agents modifiant la résistance aux chocs. A titre d'exemple, les antioxydants et stabilisants chaleur sont, par exemple, des halogénures d'alcalins, des halogénures de cuivre, des composés phénoliques stériquement encombrés, des amines aromatiques. Les stabilisants U.V. sont généralement des benzotriazoles, des benzophénones ou des HALS.

Il n'y a pas de limitation aux types d'agents modifiants la résistance aux chocs. Ce sont généralement des polymères d'élastomères qui peuvent être utilisés à cet effet. Des exemples d'élastomères convenables sont les éthylène-ester acrylique-anhydride maléique, les éthylène-propylène-anhydride maléique, les EPDM (éthylène-propylène-diène monomère) avec éventuellement un anhydride maléique greffé. La concentration pondérale en élastomère est avantageusement comprise entre 0,1 et 15 % par rapport au poids total de la composition.

Les compositions de l'invention sont obtenues par mélange des différents constituants généralement dans une extrudeuse mono ou bivis, à une température suffisante pour maintenir la résine polyamide en milieu fondu. Généralement, le mélange obtenu est extrudé sous forme de joncs qui sont coupés en morceaux pour former des granulés. Les additifs comme le graphite et l'alumine peuvent être ajoutés ensemble ou séparément, au polyamide par mélange à chaud ou à froid.

L'addition des composés et des additifs peut être réalisée par ajout de ces composés dans le polyamide fondu sous forme pure ou sous forme de mélange concentré dans une résine telle que par exemple une résine polyamide.

Les granulés obtenus sont utilisés comme matière première pour alimenter les procédés de fabrication d'articles tels que les procédés d'injection, de moulage par injection, d'extrusion et d'extrusion-soufflage. Le composant selon l'invention peut notamment être un composant extrudé ou injecté. Des articles peuvent être obtenus par mise en forme de la composition de l'invention, par toute technique de transformation plastique, comme par exemple par extrusion, tel que par exemple extrusion de feuilles et films ou extrusion soufflage ; par moulage tel que par exemple moulage par compression, moulage par thermoformage ou par rotomoulage ; par injection tel que par exemple par moulage par injection ou par injection soufflage.

Ainsi, la composition de l'invention convient particulièrement pour la fabrication d'articles utilisés dans le domaine de la connectique électrique ou électronique tels que les éléments de disjoncteurs, interrupteurs, connecteurs ou analogues. La composition selon l'invention convient particulièrement à la fabrication de composants associés à des diodes électroluminescentes tels que des boitiers, logements, supports, réflecteurs, enveloppes, capots, douilles, culots ou autres ou de composantes associés a des semi-conducteurs ou autre dans lequel le composant permet d'évacuer la quantité de chaleur dégagée par les diodes électroluminescentes en fonctionnement. Ces composants sont particulièrement fabriqués par mise en forme de la composition selon l'invention par extrusion, moulage ou injection.

La présente invention a aussi pour objet un appareil d'éclairage comprenant au moins une diode luminescente et un composant obtenu à partir d'une composition polyamide telle que décrite précédemment. L'invention concerne notamment une source électroluminescente à semi-conducteur ou lampe à diodes comprenant au moins une diode luminescente et un composant obtenu à partir d'une composition polyamide telle que décrite précédemment. De préférence les DEL sont des DEL à haute puissance, chacune avec une puissance supérieure à 10 W. Les DEL sont préférentiellement réalisées sur un même galette, appelée « wafer » de matériau semi-conducteur.

Un langage spécifique est utilisé dans la description de manière à faciliter la compréhension du principe de l'invention. Il doit néanmoins être compris qu'aucune limitation de la portée de l'invention n'est envisagée par l'utilisation de ce langage spécifique. Des modifications, améliorations et perfectionnements peuvent notamment être envisagés par une personne au fait du domaine technique concerné sur la base de ses propres connaissances générales.

Le terme et/ou inclut les significations et, ou, ainsi que toutes les autres combinaisons possibles des éléments connectés à ce terme.

D'autres détails ou avantages de l'invention apparaîtront plus clairement au vu des exemples donnés ci-dessous uniquement à titre indicatif.

### PARTIE EXPERIMENTALE

### Exemple 1 : Préparation des compositions

Composés utilisés :
- Polyamide 66 de viscosité relative 2,7 (selon la norme ISO 307 en utilisant comme solvant de l'acide sulfurique) commercialisé par la société Rhodia Engineering Plastics sous la dénomination Technyl® 27 A00.
- Mélange Maître : Phénolformalhdehyde 20 % en poids / Graphite 80 % en poids
- Alumine (oxyde d'aluminium) KAM
- Fibre de Verre OCV 983 de Owens Corning Vetrotex
- Système d'ignifugation : Exolit® OP1230 de Clariant et mélamine polyphosphate Melapur® 200
- Additifs de formulation : stabilisants thermiques et lubrifiants. 0,2 % en poids dans toute les formulations.

Pour fabriquer des compositions comprenant diverses proportions d'additifis et de charge, on mélange par extrusion, via une extrudeuse bi-vis (température de fourreau : 250-290°C, débit : 30 kg/h, rotation : 250 rpm), le polyamide et les différents additifs. Les compositions finales sont alors extrudées et granulées, puis moulées par injection. Les résultats sont répertoriés au Tableau 1.

**Tableau 1**

| **Composition** | **C1** | **C2** | **C3** | **C4** | **1** | **2** |
|---|---|---|---|---|---|---|
| PA66 | 84,3 | 39,9 | 65,9 | 31,9 | 35,9 | 45,3 |
| MM graphite | - | 30,0 | - | - | 30,0 | 30,0 |
| Alumine | - | - | 4,0 | 38,0 | 4,0 | 9,0 |
| FV | 5,0 | 5,0 | 5,0 | 5,0 | 5,0 | 5,0 |
| Exolit | 7 | 16,6 | 16,6 | 16,6 | 16,6 | 7 |
| MPP | 3,5 | 8,3 | 8,3 | 8,3 | 8,3 | 3,5 |
| | | | | | | |
| Résistivité de Surface (log Ohm carré) | 15 | 6 | 15 | 15 | 8 | 9 |
| Conductivité thermique (W/mK) | 0,1 | 1,5 | 0,5 | 1,0 | 3,0 | 3,0 |
| UL 94 @ 0,8 mm | V2 | V0 | V0 | V0 | V0 | V1 |
| Résistance à la rupture par flexion (kgf/cm²) | 1390 | 830 | 1170 | 830 | 980 | 1020 |
| Module de flexion (kgf/cm²) | 45000 | - | 42300 | - | - | 69000 |
| Choc Izod 6,4t (kgf cm/cm) | 3,8 | 2,0 | 3,0 | 1,0 | 1,8 | 2,5 |
| HDT (18,5 kgf/cm²) | 230 | 208 | 202 | 208 | 201 | 215 |

| | | | | | | |
|---|---|---|---|---|---|---|
| *Les proportions sont exprimées en pourcentage en poids par rapport au poids total de la composition* | | | | | | |

Les mesures ont été effectué avec les normes suivantes :
- Résistance aux chocs Izod selon la norme ASTM D-256
- Résistance à la rupture par flexion et module de flexion selon la norme ASTM D638
- Résistivité de surface selon la norme ASTM D257 (Standard Test Methods for DC Resistance or Conductance of Insulating Materials)
- Conductivité thermique selon la norme ASTM E1461 (Standard Test Method for Thermal Diffusivity by the Flash Method)

On observe ainsi que la combinaison selon l'invention de proportions élevées de graphite et de proportions faibles d'alumine dans la composition polyamide permet l'obtention d'un compromis unique de propriétés mécaniques, de résistivité au courant électrique et de conductivité thermique rendant apte cette composition à la fabrication d'articles pour des applications liées a des semi-conducteurs ou des diodes électroluminescentes.

## Revendications

1. Composition comprenant au moins :
a) une matrice polyamide;
b) de 2 à 30 % en poids d'alumine ;
c) de 15 à 50 % en poids de graphite ; et
d) de 5 à 40 % en poids d'un système ignifugeant
les pourcentages en poids sont exprimés par rapport au poids total de la composition.

2. Composition selon la revendication 1, **caractérisée en ce qu'**elle comprend de 20 à 80 % en poids de polyamide, par rapport au poids total de la composition.

3. Composition selon la revendication 1 ou 2, **caractérisée en ce qu'**elle comprend de 2 à 20 % en poids d'alumine.

4. Composition selon l'une quelconque des revendications 1 à 3, **caractérisée en ce qu'**elle comprend de 20 à 40 % en poids de graphite.

5. Composition selon l'une quelconque des revendications 1 à 4, **caractérisée en ce que** le graphite a été ajouté à la composition sous forme de mélange maître dans une résine.

6. Composition selon l'une quelconque des revendications 1 à 5, **caractérisée en ce que** le système d'ignifugation comprend au moins un agent ignifugeant choisi parmi le groupe comprenant : les agents ignifugeants contenant du phosphore, les agents ignifugeants de type composés organiques azotés, et les agents ignifugeants contenant des dérivés halogénés.

7. Composition selon l'une quelconque des revendications 1 à 6, **caractérisée en ce que** le système d'ignifugeant comprend au moins un acide phosphonique ou son sel ou un acides phosphinique ou son sel.

8. Composition selon l'une quelconque des revendications 1 à 7, **caractérisée en ce qu'**elle comprend des charges de renfort ou de remplissages.

9. Composants associés à des diodes électroluminescentes obtenu à partir de la composition selon l'une quelconque des revendications 1 à 8.

10. Composants selon la revendication 9 fabriqués par mise en forme de la composition par extrusion, moulage ou injection.

11. Appareil d'éclairage comprenant au moins une diode luminescente et un composant obtenu à partir d'une composition selon l'une quelconque des revendications 1 à 8.

## Patentansprüche

1. Zusammensetzung, umfassend mindestens:
a) eine Polyamidmatrix;
b) 2 bis 30 Gew.-% Aluminiumoxid;
c) 15 bis 50 Gew.-% Graphit und
d) 5 bis 40 Gew.-% eines Flammschutzsystems;
wobei die Gewichtsprozentanteile sich auf das Gesamtgewicht der Zusammensetzung beziehen.

2. Zusammensetzung nach Anspruch 1, **dadurch gekennzeichnet, dass** sie 20 bis 80 Gew.-% Polyamid, bezogen auf das Gesamtgewicht der Zusammensetzung, umfasst.

3. Zusammensetzung nach Anspruch 1 oder 2, **dadurch gekennzeichnet, dass** sie 2 bis 20 Gew.-% Aluminiumoxid umfasst.

4. Zusammensetzung nach einem der Ansprüche 1 bis 3, **dadurch gekennzeichnet, dass** sie 20 bis 40 Gew.-% Graphit umfasst.

5. Zusammensetzung nach einem der Ansprüche 1 bis 4, **dadurch gekennzeichnet, dass** der Graphit der Zusammensetzung in Form eines Masterbatch in einem Harz zugesetzt wurde.

6. Zusammensetzung nach einem der Ansprüche 1 bis 5, **dadurch gekennzeichnet, dass** das Flammschutzsystem mindestens ein Flammschutzmittel aus der Gruppe umfassend phosphorhaltige Flammschutzmittel, Flammschutzmittel vom Typ stickstoffhaltiger organischer Verbindungen und halogenierte Derivate enthaltende Flammschutzmittel umfasst.

7. Zusammensetzung nach einem der Ansprüche 1 bis 6, **dadurch gekennzeichnet, dass** das Flammschutzsystem mindestens eine Phosphonsäure oder ein Salz davon oder eine Phosphinsäure oder ein Salz davon umfasst.

8. Zusammensetzung nach einem der Ansprüche 1 bis 7, **dadurch gekennzeichnet, dass** sie verstärkende oder streckende Füllstoffe umfasst.

9. Mit Elektrolumineszenzdioden assoziierte Bauteile, erhalten aus der Zusammensetzung nach einem der Ansprüche 1 bis 8.

10. Bauteile nach Anspruch 9, hergestellt durch Formen der Zusammensetzung durch Extrusion, Abformen oder Spritzguss.

11. Beleuchtungseinrichtung, umfassend mindestens eine Lumineszenzdiode und ein aus einer Zusammensetzung nach einem der Ansprüche 1 bis 8 erhaltenes Bauteil.

## Claims

1. Composition comprising at least:
a) a polyamide matrix;
b) from 2% to 30% by weight of alumina;
c) from 15% to 50% by weight of graphite; and
d) from 5% to 40% by weight of a flame-retardant system;
the percentages by weight are expressed with respect to the total weight of the composition.

2. Composition according to Claim 1, **characterized in that** it comprises from 20% to 80% by weight of polyamide, with respect to the total weight of the composition.

3. Composition according to Claim 1 or 2, **characterized in that** it comprises from 2% to 20% by weight of alumina.

4. Composition according to any one of Claims 1 to 3, **characterized in that** it comprises from 20% to 40% by weight of graphite.

5. Composition according to any one of Claims 1 to 4, **characterized in that** the graphite was added to the composition in the form of a masterbatch in a resin.

6. Composition according to any one of Claims 1 to 5, **characterized in that** the flame-retardant system comprises at least one flame retardant selected from the group consisting of: phosphorus-comprising flame retardants, flame retardants of nitrogen-comprising organic compound type and flame retardants comprising halogenated derivatives.

7. Composition according to any one of Claims 1 to 6, **characterized in that** the flame-retardant system comprises at least one phosphonic acid or its salt or one phosphinic acid or its salt.

8. Composition according to any one of Claims 1 to 7, **characterized in that** it comprises reinforcing or bulking fillers.

9. Components associated with light-emitting diodes, obtained from the composition according to any one of Claims 1 to 8.

10. Components according to Claim 9, manufactured by shaping the composition by extrusion, molding or injection.

11. Lighting device comprising at least one light-emitting diode and one component obtained from a composition according to any one of Claims 1 to 8.
